Europäisches Patentamt

European Patent Office

Office européen des brevets

(11) Publication number: **0 491 457 A1**

## EUROPEAN PATENT APPLICATION

(21) Application number: **91307256.7**

(22) Date of filing: **07.08.91**

(51) Int. Cl.⁵: **G03F 7/34**, G03F 7/038, G03F 7/07, G03C 8/50, G03C 1/498, G03F 7/26

(30) Priority: **16.11.90 JP 308552/90**

(43) Date of publication of application:
**24.06.92 Bulletin 92/26**

(84) Designated Contracting States:
**DE FR GB**

(71) Applicant: **CANON KABUSHIKI KAISHA**
**30-2, 3-chome, Shimomaruko, Ohta-ku**
**Tokyo(JP)**

(72) Inventor: **Kobayashi, Motokazu, c/o Canon**
**Kabushiki Kaisha**
**3-30-2 Shimomaruko**
**Ohta-ku, Tokyo(JP)**
Inventor: **Shiraiwa, Yoshinobu, c/o Canon**
**Kabushiki Kaisha**
**3-30-2 Shimomaruko**
**Ohta-ku, Tokyo(JP)**
Inventor: **Isaka, Kazuo, c/o Canon Kabushiki**
**Kaisha**

**3-30-2 Shimomaruko**
**Ohta-ku, Tokyo(JP)**
Inventor: **Matsumoto, Kenichi, c/o Canon**
**Kabushiki Kaisha**
**3-30-2 Shimomaruko**
**Ohta-ku, Tokyo(JP)**
Inventor: **Yuasa, Toshiya, c/o Canon**
**Kabushiki Kaisha**
**3-30-2 Shimomaruko**
**Ohta-ku, Tokyo(JP)**
Inventor: **Mouri, Akihiro, c/o Canon Kabushiki**
**Kaisha**
**3-30-2 Shimomaruko**
**Ohta-ku, Tokyo(JP)**

(74) Representative: **Beresford, Keith Denis Lewis**
**et al**
**BERESFORD & Co. 2-5 Warwick Court High**
**Holborn**
**London WC1R 5DJ(GB)**

(54) **Image forming method and apparatus.**

(57) An image is formed by forming a polymerized part and an un-polymerized part in a polymerization layer (4) disposed between a support (5) and a release film (3) of an image forming medium, and then peeling the release film to leave an image on the support. In order to prevent the deterioration or lack of the image, an image pattern corresponding to the image and comprising unidirectionally elongated pixels (20) is formed so that the pixels are composed of either the polymerized part or the un-polymerized part. Then, the release film is peeled off in the direction (A) of the elongation of the pixels. In order to promote the peeling initiation, a peeling promotion end-forming layer comprising a material capable of decreasing its adhesiveness on heating may be further disposed adjacent to the polymerization layer and sandwiched between the support and the release film so as to extend along one end of the release film.

EP 0 491 457 A1

F I G. I

## FIELD OF THE INVENTION AND RELATED ART

The present invention relates to an image forming method usable for producing a printing plate, etc., more particularly an image forming method of a peeling development-type wherein a photopolymerizable composition is polymerized patternwise, followed by selective removal by peeling of the yet-unpolymerized part or the polymerized part to form an image, and an apparatus for performing such a method.

As an image forming medium used in an image forming method of the peeling development-type, there is for example known one which comprises a thermal development-type photosensitive composition layer comprising a silver salt, etc., a peeling development-type photopolymerizable composition layer, a release film, and a support. The thermal development-type photosensitive composition is used for image formation through photo-exposure and heating.

In an image forming method using such an image forming medium, the image forming medium is loaded on a camera for plate production; an original, a lens and the image forming medium are set with appropriate distances therebetween and subjected to imagewise exposure; the image forming medium is heated to form a silver image and then subjected to whole-area exposure through the silver image as a mask; and then development by peeling is performed. As a result, an image of the photopolymerizable composition layer exposed and selectively cured by polymerization corresponding to the original image is formed on the support.

In the above-described method, when the release film is peeled, an image part of the photopolymerizable composition layer (i.e., a part to be left as an image on the support) can sometimes be also peeled, or a non-image part (a part to be removed by peeling) can sometimes remain, thus failing to provide a good image.

In order to facilitate the peeling of the release film, it has been proposed to have a peeling boundary line intersect a continuous linear pattern in Japanese Laid-Open Patent Appln. (JP-A) 58-53882. Herein, the peeling boundary line refers to a boundary between a peeled part and a yet-unpeeled part when two sheets bonded to each other are peeled from each other.

The above-proposed technique is effective in case where an image is composed of continuous straight lines extending in parallel in a specified direction but fails to provide a good image due to awkward peeling in case where an image pattern is composed of curved lines or mutually intersecting straight lines in mixture.

## SUMMARY OF THE INVENTION

An object of the present invention is to provide an image forming method having solved the above-mentioned problems of the conventional method to provide high quality images, and an apparatus therefor.

According to the present invention, there is provided an image forming method of a peeling development-type, comprising:

providing an image forming medium comprising a support, a polymerization layer comprising a polymerizable composition, and a release film;

irradiating the image forming medium with image data to form an image pattern in the polymerization layer, so that the image pattern includes a polymerized part and an un-polymerized part and comprises unidirectionally elongated pixels composed of either the polymerized part or the un-polymerized part; and

peeling the release film off the support in a direction of the elongation of the pixels to selectively leave an image corresponding to the image pattern on the support.

These and other objects, features and advantages of the present invention will become more apparent upon a consideration of the following description of the preferred embodiments of the present invention taken in conjunction with the accompanying drawings, wherein like parts are denoted by like reference numerals.

## BRIEF DESCRIPTION OF THE DRAWINGS

Figure 1 is a schematic overlook view for illustrating the peeling direction of a release film according to the present invention.

Figures 2, 3, 4A - 4B, 5, 6 and 7 are respectively a schematic plan view for illustrating an exposure-writing pattern according to an embodiment of the present invention.

Figures 8 and 9 are schematic views for illustrating essential parts of an image forming apparatus used in an embodiment.

Figures 10 - 12 are respectively a schematic sectional view of an image forming medium usable in the present invention.

Figures 13 and 14 are schematic sectional views for illustrating another embodiment of the image forming method according to the present invention using the image forming medium shown in Figure 12.

DETAILED DESCRIPTION OF THE PREFERRED EMBODIMENTS

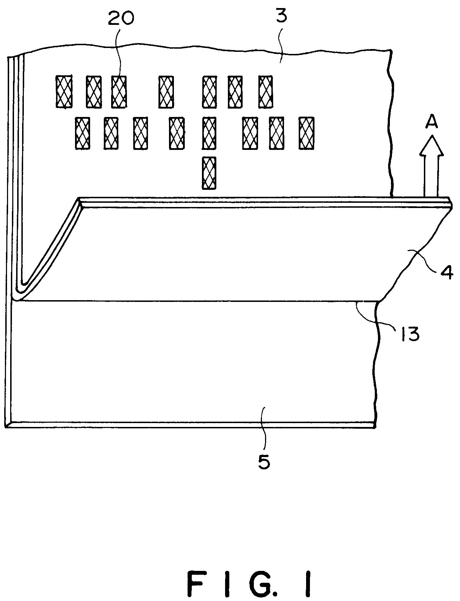

In a representative embodiment of the present invention, a pattern is formed by assemblage of plural pixels or dots (polymerized parts or unpolymerized parts of the photopolymerizable layer to remain on a support) in the photopolymerizable layer, and the pixels (dots) are caused to have a unidirectionally elongated shape such as a rectangle or an oval and are uniformized in their longitudinal direction, with which the peeling direction of the release film is caused to coincide. When the release film is peeled off, some peeling force also acts on the parts (pixels dots) of the polymerizable layer expected to remain on the support. According to the above arrangement, however, the peeling force acting on the dots is alleviated, so that the dots do not (readily) collapse or the pattern is not readily deformed to leave a high quality image. Figure 1 illustrates a peeling direction A of a release film 3 relative to rectangular dots 20 formed by exposure of an image forming medium for forming an image in a photopolymerization layer 4 on a support 5. Thus, the release film 3 is peeled from the support together with a substantial part of the photopolymerization layer 4 which forming a peeling boundary line 13 extending perpendicularly to the longitudinal direction of the dots 20.

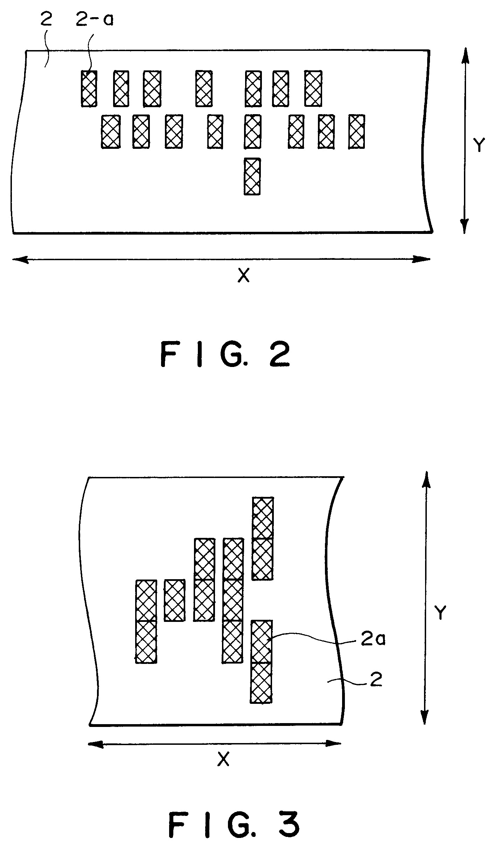

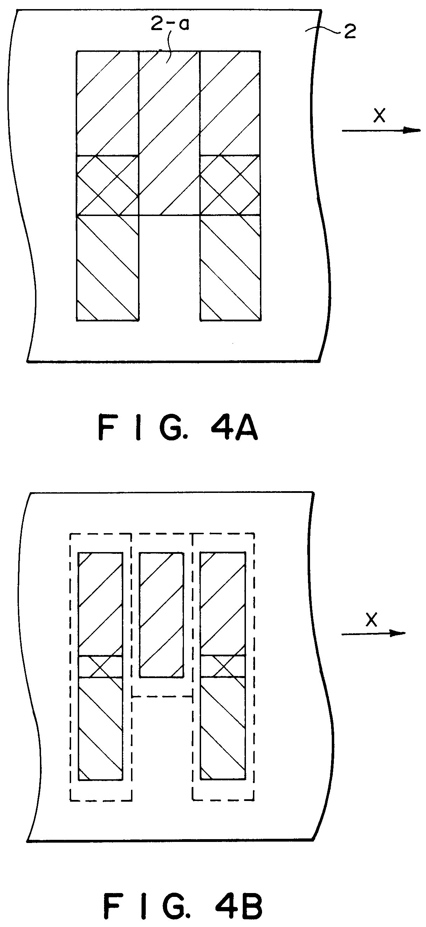

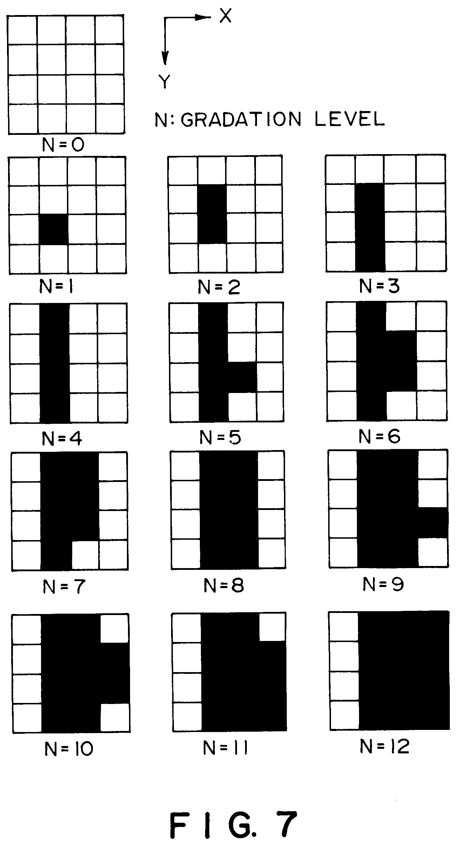

Herein, the term "dot" refers to a minimum element constituting an image pattern. The term "pixel" is used to mean a dot when an image pattern is composed of discrete dots as shown in Figures 1 and 2 explained hereinafter but is used to rather mean a plurality of connected dots as shown in Figures 3, 4A, 4B and 5 - 7 when an image pattern is formed as an assemblage of pixels (each comprising such a plurality of connected dots or a discrete dot still joining as an element of the image pattern). A unidirectionally elongated pixel used in the present invention may generally be constituted by a unidirectionally elongated dot (Figures 1 and 2) or a plurality of connected dots each unidirectionally elongated (Figures 4 - 6) but can also be constituted by a plurality of non-elongated dots which are preferentially connected in one direction (Figure 7).

Now, an explanation is made to an image forming medium usable in the present invention.

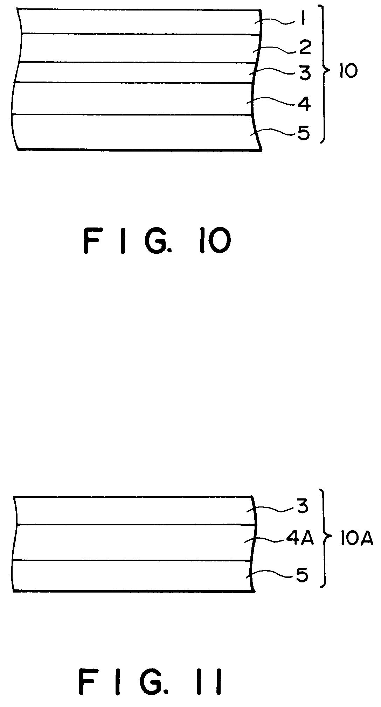

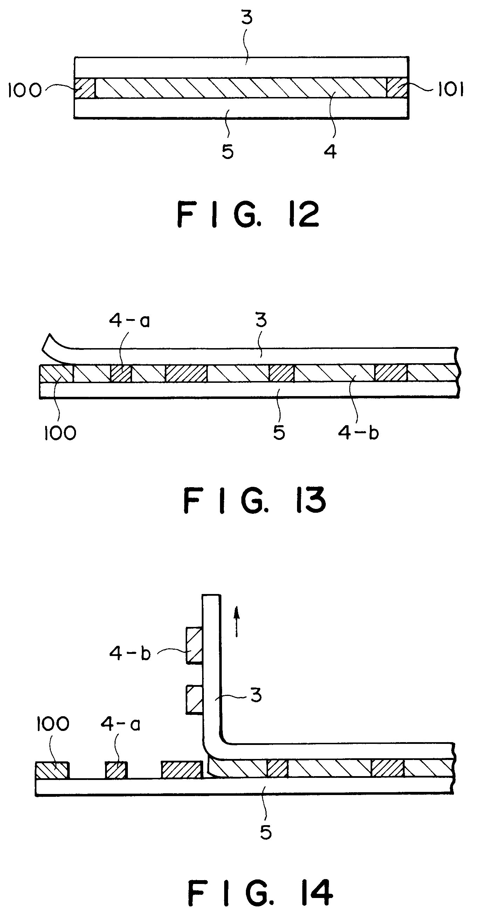

The image forming medium used the present invention may include a multi-layer structure individually including a photosensitive layer 2 comprising a thermal development-type photosensitive composition and a photopolymerization layer 4 comprising a peeling development-type photopolymerizable composition as shown in Figure 10, or a single-layer structure including a composite layer 4A comprising both a thermal development-type photosensitive composition and a photopolymerizable composition as shown in Figure 11.

More specifically, referring to Figure 10, the image forming medium includes a protective film 1 covering the photosensitive layer 2 which is disposed on a release film 3 to be removed by peeling together with non-image part of the photopolymerization layer 4. In the single-layer structure shown in Figure 11, a peeling film 3 may be also used as a protective layer. In both structures, a support 5 is used to support the entire structure.

It is also possible to dispose an undercoating layer (not shown) containing a halation-preventing dye, a polymer binder, etc., for preventing halation or improvement of adhesiveness between the support 5 and the photopolymerization layer 4 or the composite layer 4A.

The protective film 1 and the release film 3 may respectively comprise a plastic or resin, such as polyethylene terephthalate, polypropylene, polyethylene, cellophane, polyimide, 6,6-nylon, polystyrene, polyvinyl alcohol, or polyvinyl butyral. The films may also comprise a composite material obtained by mixing two or more such resins.

The thermal development-type photosensitive composition may comprise at least a photosensitive silver halide, an organic silver salt and a specific reducing agent, and the photopolymerization layer may comprise at least a polymerizable polymer precursor and a photopolymerization initiator.

The silver halide contained in the thermal development-type photosensitive composition may be a known silver halide used in photography, etc., such as silver chloride, silver bromide, silver iodide, silver chlorobromide, silver iodochloride, silver iodobromide, or silver chloroiodobromide.

The halogen content in the silver halide particles may be uniform or ununiform from the surface to the core. The silver halide particles may have a particle size of preferably 0.001 - 10 microns, further preferably 0.001 - 5 microns.

The photosensitive silver salt may be or may have been subjected to chemical sensitization or optical sensitization as done in respect of usual photographic emulsions. More specifically, the chemical sensitiza-

4

tion that can be used includes sulfur sensitization, noble metal sensitization, and reduction sensitization. The optical sensitization that can be applied includes methods using conventionally known sensitizing dyes, such as cyanine dyes and merocyanine dyes.

The organic silver salt that can be used in the medium of the present invention may include, for example, silver salts of aliphatic carboxylic acids, aromatic carboxylic acids, mercapto or thiocarbonyl compounds having an $\alpha$-hydrogen, and imino group-containing compounds.

The aliphatic carboxylic acids include acetic acid, butyric acid, succinic acid, sebacic acid, adipic acid, oleic acid, linolic acid, linolenic acid, tartaric acid, palmitic acid, stearic acid, behenic acid and camphor acid. In general, however, silver salts are less stable as they have a smaller number of carbon atoms, and hence those having an appropriate number of carbon atoms, e.g., 16 to 26 carbon atoms, are preferred.

The aromatic carboxylic acids include benzoic acid derivatives, quinolinic acid derivatives, naphthalenecarboxylic acid derivatives, salicylic acid derivatives, gallic acid, tannic acid, phthalic acid, phenylacetic acid derivatives, and pyromellitic acid.

The mercapto or thiocarbonyl compounds include 3-mercapto-4-phenyl-1,2,4-triazole, 2-mercaptobenzoimidazole, 2-mercapto-5-aminothiadiazole, 2-mercaptobenzothiazole, s-alkylthioglycolic acid (alkyl group carbon atom number of 12 to 22), dithiocarboxylic acids such as dithioacetic acid, thioamides such as thiostearoamide, and mercapto compounds such as 5-carboxy-1-methyl-2-phenyl-4-thiopyridine, mercaptotriazine, 2-mercaptobenzoxazole, mercaptooxadiazole, and 3-amino-5-benzylthio-1,2,4-triazole, which are described in U.S. Patent No. 4,123,274.

The compounds having an imino group typically include benzotriazole or derivatives thereof, described in Japanese Patent Publication JP-B 44-30271 or JP-B 42-18416, as exemplified by benzotriazole and alkyl-substituted benzotriazoles such as methylbenzotriazole, halogen-substituted benzotriazoles such as 5-chlorobenzotriazole, carboimidobenzotriazoles such as butylcarboimidobenzotriazole, nitrobenzotriazoles, described in Japanese Laid-Open Patent Application JP-A 58-118638, sulfobenzotriazole, carboxybenzotriazole or salts thereof, or hydroxybenzotriazole, described in Japanese Laid-Open Patent Application JP-A 58-118639, 1,2,4-triazole, described in U.S. Patent No. 4,220,709, or 1H-tetrazole, carbazole, saccharin, imidazole, and derivatives thereof.

The reducing agent may be one which causes a redox reaction under heating with an organic silver salt in the presence of a silver latent image from the photosensitive silver salt as catalyst to produce a silver image absorbing light in the absorption wavelength range of the photopolymerization layer to reduce the transmitted light quantity, or one which results in an oxidized product through a similar redox reaction absorbing light in the absorption wavelength range of the photopolymerization initiator.

More specifically, examples of the reducing agent usable in the present invention may include reducing agents disclosed in "SHASHIN KOGAKU NO KISO, HIGIN-EN HEN (Basis of Photolithographic Industry, Volume of Non-silver Salt)" p. 250 - , primary color developing agents, and secondary color developing agents. Specific examples thereof may include: phenols, hydroquinones, catechols, p-aminophenol, p-substituted aminophenols, p-phenylenediamines, 3-pyrazolidones; in addition, resorcines, pyrogallols, o-aminophenols, m-aminophenols, m-phenylenediamines, 5-pyrazolones, alkylphenols, alkoxyphenols, naphthols, aminonaphtols, naphtholenediols, alkoxynaphthols, hydrazines, hydrazones, hydroxychromanehydroxycoumarans, sulfonamidophenols, aminonaphthols, ascorbic acid and its derivatives, hydroxyindanes, bisphenols and orthobisphenols.

Further, leuco bases obtained by reducing a class of dyes may also be used as a reducing agent.

It is further possible to use two or more species of the above-mentioned reducing agents in combination. When a secondary color developing agent is used, it may preferably be used in combination with a coupler which reacts with an oxidation product of the secondary color developing agent to form a light-absorbing compound.

Specific examples of the reducing agent may include: hydroquinone, hydroquinone monomethyl ether, 2,4-dimethyl-6-t-butylphenol, catechol, dichlorocatechol, 2-methylcatechol, methyl gallate, ethyl gallate, o-aminophenol, 3,5-dimethyl-2-aminophenol, p-aminophenol, p-amino-o-methylphenol, m-dimethylaminophenol, m-diethylaminophenyl, 2,6-dicyclohexyl-4-methylphenol, 1-naphthol, 2-methyl-1-naphthol, 2,4-dichloro-1-naphthol, 1,1-di-2-naphthol, 2,2'-methylenebis(4-methyl-6-t-butylphenol), 2,2'-methylenebis(4-ethyl-6-t-butylphenol), 2,2'-butylidenebis(4-methyl-6-t-butylphenol), 4,4'-butylidenebis(3-methyl-6-t-butylphenol), 4,4'-methylenebis(2,6-di-t-butylphenol), 1,1,3-tris(2-methyl-4-hydroxy-5-t-butylphenol)butane, 4,4'-thiobis(3-methyl-6-t-butylphenol, 2,4-bis(ethylthio)-6-(4-hydroxy-3,5-di-t-butylanilino)-1,3,5-triazine, 2,4-bis(octylthio)-6-(4-hydroxy-3,5-di-t-butylanilino)-1,3,5-triazine, 2,6-dichloro-4-benzenesulfonamidophenol, 2-chloro-4-benzenesulfonamidophenol, 2,6-dibromo-4-benzenesulfonamidophenol, thioindoxyl, indoxyl, 1,3-dimethylpyrogallol, 4-methoxynaphthol, 4-ethoxynaphthol, 2-cyanoacetylcoumarone, N,N-dimethylphenylenediamine, N,N-diethylphenylenediamine and N',N'-diethyl-3-methylphenylenediamine.

Further, examples of the coupler used in combination with a secondary color developing agent (of, e.g., the phenylenediamine-type or p-aminophenol-type) may include: 1-hydroxy-N-butyl-2-naphthamide, benzoylacetone, benzoylacetanilide, o-methoxybenzoyl-aceto-o-methoxyanilide, dibenzoylmethane, 2-chloro-1-naphthol, 2,6-dibromo-1,5-naphthalenediol, and 3-methyl-1-phenylpyrazolone.

The light-absorbing compound may be one classified or not classified under the category of colorants or dyes, if it substantially attenuate the sensitivity of the photopolymerization initiator. In case where absorption in the ultraviolet range for example is utilized, absorption in the visible range is not questioned.

As for the combination of the light-absorbing compound and the photopolymerization initiator, when 4,4'-methylenebis(2-methyl-6-t-butylphenol), 4,4'-methylenebis(2,6-di-t-butylphenol) or the like, for example, is used as a reducing agent, it is possible to use a photopolymerization initiator having a sensitivity to 380 - 390 nm, such as 2-chlorothioxanthone, 2-methylthioxanthone, 2,4-dimethylthioxanthone, 2,4,6-trimethylbenzoyldiphenylphosphine oxide, and benzyl.

Further, 2,6-di-tert-butyl-4-benzylphenol, 1-(3,5-di-t-butyl-4-hydroxyphenyl)-1-phenylethane or a secondary color developing agent forming a cyane colorant may be used in combination with a photopolymerization initiator having a sensitivity to 300 - 370 nm in addition to the visible region, such as 1-phenyl-2-hydroxy-2-methylpropane-1-one, 1-hydroxycyclohexyl phenyl ketone, benzoin dimethyl ether, benzophenone, 4-benzoyl-4'-methyldiphenyl sulfide.

The polymerizable polymer precursor as a component of the peeling development-type photopolymerization composition may be a compound having at least one reactive vinyl group in its molecule. The reactive vinyl group in these compounds includes substituted or unsubstituted vinyl groups having polymerization reactivity, as exemplified by styrene type vinyl groups, acrylic acid type vinyl groups, methacrylic acid type vinyl groups, allyl type vinyl groups, and vinyl ether type vinyl groups, as well as ester vinyl groups as in vinyl acetate.

Examples of the polymerizable polymer precursor satisfying such conditions may include, for example;

monofunctional monomers such as styrene, methylstyrene, chlorostyrene, bromostyrene, methoxystyrene, dimethylaminostyrene, cyanostyrene, nitrostyrene, hydroxystyrene, aminostyrene, carboxystyrene, acrylic acid, methyl acrylate, ethyl acrylate, cyclohexyl acrylate, acrylamide, methacrylic acid, methyl methacrylate, ethyl methacrylate, propyl methacrylate, butyl methacrylate, phenyl methacrylate, cyclohexyl methacrylate, vinyl pyridine, N-vinylpyrrolidone, N-vinylimidazole, 2-vinylimidazole, N-methyl-2-vinylimidazole, propyl vinyl ether, butyl vinyl ether, isobutyl vinyl ether, $\beta$-chloroethyl vinyl ether, phenyl vinyl ether, p-methylphenyl vinyl ether, and p-chlorophenyl vinyl ether;

difunctional monomers such as divinylbenzene, distyryl oxalate, distyryl malonate, distyryl succinate, distyryl glutarate, distyryl adipate, distyryl maleate, distyryl fumarate, distyryl $\beta,\beta'$-dimethylglutarate, distyryl 2-bromoglutarate, distyryl $\alpha,\alpha'$-dichloroglutarate, distyryl terephthalate, oxalic acid di(ethyl acrylate), oxalic acid di(methyl ethyl acrylate), malonic acid di(ethyl acrylate), malonic acid di(methyl ethyl acrylate), succinic acid di(ethyl acrylate), glutaric acid di(ethyl acrylate), adipic acid di(ethyl acrylate), maleic acid di-(diethyl acrylate), fumaric acid di(ethyl acrylate), $\beta,\beta'$-dimethylglutaric acid di(ethyl acrylate), ethylenediacrylamide, propylenediacrylamide, 1,4-phenylenediacrylamide, 1,4-phenylenebis(oxyethyl acrylate), 1,4-phenylenebis(oxymethyl ethyl acrylate), 1,4-bis(acryloyloxyethoxy)cyclohexane, 1,4-bis-(acryloyloxymethylethoxy)cyclohexane, 1,4-bis(acryloyloxyethoxycarbamoyl)benzene, 1,4-bis-(acryloyloxymethylethoxycarbamoyl)benzene, 1,4-bis(acryloyloxyethoxycarbamoyl)cyclohexane, bis-(acryloyloxyethoxycarbamoylcyclohexyl)methane, oxalic acid di(ethyl methacrylate), oxalic acid di(methyl ethyl methacrylate), malonic acid di(ethyl methacrylate), malonic acid di(methyl ethyl methacrylate), succinic acid di(ethyl methacrylate), succinic acid di(methyl ethyl methacrylate), glutaric acid di(ethyl methacrylate), adipic acid di(ethyl methacrylate), maleic acid di(ethyl methacrylate), fumaric acid di(ethyl methacrylate), fumaric acid di(methyl ethyl methacrylate), $\beta,\beta'$-dimethylglutaric acid di(ethyl methacrylate), 1,4-phenylenebis(oxyethyl methacrylate), and 1,4-bis(methacryloyloxyethoxy)cyclohexane acryloyloxyethoxyethyl vinyl ether;

trifunctional monomers such as pentaerythritol triacrylate, pentaerythritol trimethacrylate, pentaerythritol tri(hydroxystyrene), cyanuric acid triacrylate, cyarnuric acid trimethacrylate, 1,1,1-trimethylolpropane triacrylate, 1,1,1-trimethylolpropane trimethacrylate, cyanuric acid tri(ethyl acrylate), 1,1,1-trimethylolpropane tri(ethylacrylate), dipentaerythritol hexaacrylate, cyanuric acid tri(ethyl vinyl ether), a condensate of a reaction product between 1,1,1-trimethylolpropane and three-fold moles of toluenediisocyanate, with hydroxyethyl acrylate, and a condensate of a reaction product pattern 1,1,1-trimethylolpropane and three-fold moles of hexanediisocyanate, with p-hydroxystyrene; and

tetrafunctional monomers such as ethylenetetraacrylamide, and propylenetetraacrylamide. Two or more of these polymerizable polymer precursors can be used in combination.

The photopolymerization initiator used in the present invention may include, for example, carbonyl compounds, sulfur compounds, halogen compounds, photopolymerization initiators of redox type, and peroxide initiators sensitized with dye such as pyrilium.

Specifically, the carbonyl compounds include diketones as exemplified by phenyl, 4,4'-dimethoxybenzyl, diacetyl, and camphorquinone; benzophenones as exemplified by 4,4'-bis(diethylamino)benzophenone, and 4,4'-dimethoxylbenzophenone; acetophenones as exemplified by acetophenone, and 4-methoxyacetophenone; benzoin alkyl ethers; thioxanthones as exemplified by 2-chlorothioxanthone, 2,4-dichlorothixanthone, 2,4-diethylthioxanthone, and thioxanthone-3-carboxylic acid-β-methoxy ethyl ester; chalcones and styrylketones having a dialkylamino group; and cumarins as exemlified by 3,3'-carbonylbis(7-methoxycumarin), and 3,3'-carbonylbis(7-diethylaminocumarin).

The sulfur compounds include disulfides as exemplified by dibenzothiazolyl sulfide, and decylphenyl sulfide.

The halogen compounds include, for example, carbon tetrabromide, quinolinesulfonyl chloride, and S-triazines having a trihalomethyl group.

The photopolymerization initiators of redox typo include those used in combination of a trivalent iron compound (as exemplified by ferric ammonium citrate) with a peroxide, and those used in combination of a photoreducing coloring matter such as riboflavin or Methylene Blue with a reducing agent such as triethanolamine or ascorbic acid.

In the photopolymerization initiator described above (including the sensitizer), two or more photopolymerization initiators can also be used in combination to effect a more efficient photopolymerization reaction.

Such combination of the photopolymerization initiators includes a combination of styryl ketones or chalcones having a dialkylamino group or cumarins, with S-triazines having a trihalomethyl group or camphorquinone.

Further, in addition to the above-mentioned components including the photosensitive silver salt and reducing agent, it is possible to add an optional component, such as a binder or film-forming agent, a color-adjusting agent, a fog-preventing agent, a photo-color denaturation-preventing agent, a solid solvent, a surfactant, or an anti-static agent.

The binder or film-forming agent usable in the present invention may include, for example: cellulose esters, such as nitrocellulose, cellulose phosphate, cellulose sulfate, cellulose acetate, cellulose propionate, cellulose butyrate, cellulose myrystate, cellulose palmitate, cellulose acetate propionate, and cellulose acetate butyrate; cellulose ethers, such as methyl cellulose, ethyl cellulose, propyl cellulose, and butyl cellulose; vinyl resins, such as polystyrene, polyvinyl chloride, polyvinyl acetate, polyvinyl butyral, polyvinyl acetal, polyvinyl alcohol, and polyvinyl pyrrolidone; copolymer resins, such as a styrene/butadiene copolymer, a styrene/acrylonitrile copolymer, a styrene/butadiene/acrylonitrile copolymer, and a vinyl chloride/vinyl acetate copolymer; acrylic resins, such as polymethyl methacrylate, polymethyl acrylate, polybutyl acrylate, polyacrylic acid, polymethacrylic acid, polyacrylamide, and polyacrylonitrile; polyesters, such as polyethylene terephthalate; polyarylate resins, such as poly(4,4'-isopropylidene, diphenylene-co-1,4-cyclohexylenedimethylene carbonate), poly(ethylenedioxy-3,3'-phenylene thiocarbonate), poly(4,4'-isopropylidene, diphenylene carbonate-co-terephthalate), poly(4,4'-isopropylidene,diphenylene carbonate), poly(4,4'-sec-butylidene,diphenylene carbonate), and poly(4,4'-isopropylidene,diphenylene carbonate-blockoxyethylene); plyamides; polyimides; epoxy resins; phenolic resins; polyolefins, such as polyethylene, polypropylene, and chlorinated polyethylene; and natural polymers, such as gelatin.

In addition to the above, optional components, such as a color-adjusting agent, a fog-preventing agent, an alkali generating agent, etc., may be incorporated in the matrix phases or the particles, as desired.

A photopolymerization layer as described above may also be commercially available. An example of the commercially available product is "Neotrock" (trade name, mfd. by Nitto Denko K.K.).

The image forming medium is not required to have a particular shape but may be in the form of a flat plate, a cylinder, a roll, etc.

The photosensitive layer 2 may preferably have a thickness of about 0.1 micron - 2 mm, more preferably about 1 micron - 0.1 mm.

The photopolymerization layer 4 may preferably have a thickness of about 0.2 - 100 microns, particularly 0.5 - 50 microns.

The release film 3 may preferably have a thickness of 0.5 - 150 microns, particularly 1 - 50 microns.

The composite layer 4A (Figure 11) having functions of both a photosensitive layer and a photopolymerization layer, may preferably have a thickness of 0.1 micron - 2 mm, particularly 1 micron - 0.1 mm.

The protective film 1 and support 5 may be in the form of a film or plate having an appropriate thickness of at least 1 micron.

The image forming medium can also be provided with a peeling end for facilitating the commencement of the peeling as described in Japanese Laid-Open Patent Applications JP-A 59-181341, JP-A 60-69650 and JP-A 60-225151.

The thus-formed image may also be widely applicable as a printing plate.

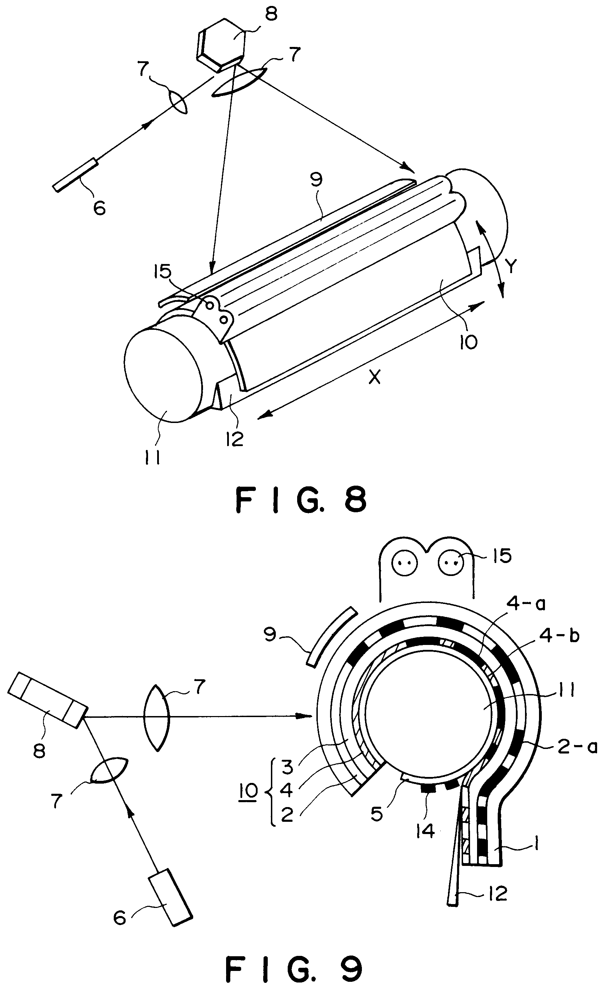

An embodiment of the image forming method according to the present invention using a multi-layer image forming medium as shown in Figure 10 and an apparatus as illustrated in Figures 8 and 9, will now be explained.

Referring to Figures 8 and 9, an image forming medium 10 including the layers 1 - 5 and wound about a drum 11 is scanned with light issued from a laser 6 as a light source and scanningly deflected by a polygonal mirror 8 in a direction of the drum 11 axis, which is referred to as a main scanning direction X. The image forming medium 10 is moved along with the rotation of the drum in the peripheral direction of the drum 11, which is referred to as a sub-scanning direction Y. A separation claw for peeling the release film 3 from the support 5 is disposed parallel to the drum and acts to cause the peeling as the image forming medium after the photopolymerization is sent thereto, so that the peeling direction coincides with the sub-scanning direction. Accordingly, it is necessary to form pixels (or dots) constituting an image so that they are elongated in the sub-scanning direction. This arrangement is preferred because the peeling is performed automatically along with the movement of the image forming medium only by provision of such a separation claw. It is however of course possible to make the scanning direction and the peeling direction unrelated with each other if the peeling is performed manually.

First, the photosensitive layer 4 of the image forming medium 10 is exposed imagewise to light to which the thermal development-type photosensitive composition is sensitive (e.g., visible rays having a wavelength shorter than about 800 nm, ultraviolet rays, X rays, $\gamma$ rays and electron beam) which has passed through a scanning optical system.

The image forming medium is scanningly irradiated with spots of light having a shorter length in the main scanning direction X than in the sub-scanning direction Y as the spots correspond to the dots constituting a pattern of image. A preferred spot size, thus corresponding to a pixel (or dot) size, is 2 - 150 microns, particularly 5 - 100 microns, in the main scanning direction and 5 - 200 microns, particularly 10 - 150 microns, in the sub-scanning direction. The ratio of the layer size (axis) to the shorter size (axis) may preferably be in the range of about 120 - 400:100. A larger spot size than the specified range will provide a poor resolution, and a smaller spot size results in a difficulty in peeling development.

The size and shape of the spots may be determined by various sets in the scanning optical system or by pulse duration modulation of the light source. By pulse duration modulation, it is also possible to express an areal gradation.

Examples of the light source 6 which may issue light rays to which the thermal development-type photosensitive composition is sensitive may include: a tungsten lamp, a mercury lamp, a halogen lamp, a laser, a CRT, an arc discharge lamp, a fluorescent lamp, and an X-ray source.

Then, the image forming medium exposed imagewise is heated at a temperature of preferably 80 - 200 °C, further preferably 100 - 150 °C, to form a silver image at the exposed portion of the photosensitive layer 4. Then, the photopolymerization layer 4 is exposed through the photosensitive layer 2 having the silver image to light to which the photopolymerization layer is sensitive, such as visible rays having a wavelength shorter than about 550 nm, ultraviolet rays, X-rays, and electron beam.

Then, the release film 3 is peeled off. In this instance, the photopolymerization layer 4 shows different adhesive forces to the release film 3 at the polymerized portions and the non-polymerized portions thereof, and the portions showing a stronger adhesive force of the photopolymerization layer are peeled together with the release film to leave the portions showing a weaker adhesive force on the support 5 to form an image 14.

At the time of peeling, the peeling boundary line 13 is caused to extend perpendicularly to the sub-scanning direction Y. If the peeling boundary line is made perpendicular to the main scanning direction X, the peeling boundary line is parallel to the direction of elongation of the spots formed by the scanning optical system, so that a large force is required for the peeling and the peeling speed becomes ununiform to result in unintentional removal of an image portion to be retained on the support or remaining of a portion to be peeled off together with the release film.

On the other hand, if the peeling is performed with the peeling boundary line extending perpendicularly to the sub-scanning direction, the peeling boundary line is made perpendicular to the direction of elongation of the spots, so that the peeling development can be performed smoothly at a small force to minimize the lack of an image.

Referring to Figure 9, un-polymerized parts 4-b are formed in the photopolymerization layer 4 corresponding to the spotwise laser-exposed parts 2-a in the photosensitive layer 2 and the polymerized parts 4-a are caused to remain on the support 5. Thus, the laser spots and the image form mutually inverted patterns with respect to each other in this embodiment. In the present invention, regardless of whether or not a final image is inverted in pattern from laser beam-irradiated spots, the portions expected to remain on the support are faithfully left and the portions expected to be removed are faithfully peeled off to result in a high quality image anyway.

The peeling embodiment in the present invention may be performed manually or may be performed mechanically as a continuous step. The mechanical peeling may be performed by using a peeling roller instead of a separating claw as described above. The peeling angle and the peeling speed may be set to arbitrary values.

Hereinbelow, the present invention will be explained based on some specific Examples, wherein "parts" are "parts by weight".

Example 1

A multi-layer image forming medium as shown in Figure 10 was prepared.

A photopolymerization layer sandwich ("Neotrock E", available from Nitto Denko K.K.) having a 20 micron-thick photopolymerization layer sandwiched between a 16 micron-thick polyester base film and a 25 micron-thick cover film was provided.

A 100 micron-thick aluminum plate cleaned for removal of rust and stain on the surface and subjected to surface roughening by sanding was used as a support and laminated with the above photopolymerization layer sandwich while removing the cover film, thereby to form a partial laminate structure including a photopolymerization layer ("Neotrock E") 4 and a release film (the base film of "Neotrock E") 3 disposed on the support 5.

Then, an emulsion was prepared according to the following composition:

```
Silver behenate                                   5.0  part(s)

Behenic acid                                      2.0      "

Silver bromide                                    0.6      "

Polyvinyl butyral                                 5.0      "

4,4'-Methylenebis(2,6-di-t-

   butylphenol)                                   3.0      "

Phthaladinone                                     0.8      "

1-Carboxymethyl-5-[(3-ethylnaphtho-

   [1,2-d]oxazoline-2-indene)-diethylidene]-

   3-ethylthiohydrantoin                          0.001    "

Xylene/n-butanol (1/1 by volume)                   60      "
```

The emulsion was applied on the release film 3 and dried to form a 8 micron-thick photosensitive layer 2.

Further, the photosensitive layer 2 was laminated with a 15 micron-thick polyester film as a protective film 1 to obtain an image forming method 10 as shown in Figure 10.

The thus prepared image forming medium 10 was loaded on an image forming apparatus as shown in Figure 8 (schematic perspective view) and Figure 9 (schematic sectional view) and subjected to image formation.

More specifically, the image forming medium 10 prepared above was wound about a drum 11 and subjected to exposure-writing of a pattern with a laser beam (633 nm) issued from an He-Ne laser 6, having passed through a scanning optical system including lenses 7 and a polygonal mirror 8 and forming beam spots each having sizes of 50 microns in the main scanning direction X and 100 microns in the sub-scanning direction Y on the surface of the image forming medium 10. Then, a part of image forming medium 10 subjected to the exposure writing was heated by a heat-generating member 9 set at 125 ºC to form silver image dots 2-a at the exposed parts in the photosensitive layer 2.

In this instance, the pattern was formed so that the silver image dots 2-a adjacent to each other did not contact each other in either of the main scanning direction X and the sub-scanning direction Y as shown in Figure 2.

The image forming medium 10 having the photosensitive layer 2 having the thus-formed silver image dots 2-a as a mask was subjected to a whole-area exposure to a fluorescent light having a peakwavelength of 380 nm from a high-voltage mercury lamp 15 to form photopolymerized parts 4-a constituting an image in the photopolymerization layer 4.

Then, the release film 3 was peeled off from the support 5 by a peeling claw 12 to leave a good image pattern 14 composed of photopolymerized parts 4-a, which image was free from lack of the polymerized parts and residue of un-polymerized parts 4-b. The peeling direction at this time was caused to agree with the sub-scanning direction, i.e., the direction of elongation of the laser-exposure dots.

## Example 2

An image formation test was performed similarly as in Example 1 except that the pattern exposure-writing with a laser beam was modified as follows.

Thus, an exposure image was formed in the photosensitive layer 2 by recording dots 2-a each having sizes of 40 microns in the main scanning direction X and 100 microns in the sub-scanning direction Y with a spacing of 1 - 20 % of the dot width in the main scanning direction X and no spacing (exact contact) between dots in the sub scanning direction as shown in Figure 3.

A high-quality image was obtained similarly as in Example 1.

## Comparative Example 1

Example 1 was repeated up to the whole-area exposure with the mercury lamp for photopolymerization. Then, the image forming medium 10 was peeled off from the drum 11, and then the release film 2 as peeled off from the support 5 in the main scanning direction X, whereby some lack was observed in the image remaining on the support 5.

## Example 3

An image formation test was performed similarly as in Example 1 except that the exposure-writing with a laser beam was modified as follows.

Laser beam scanning was performed by intensity modulation (A/O modulation) of an He-Ne laser so that one recording dot formed by a 100 %-intensity emission of the laser beam was longer in the sub-scanning direction than in the main scanning direction X as shown in Figure 4A by setting of the optical system, the main scan recording density and the sub-scan interval. In the case of the continuous emission of the laser beam, the recording dots were formed continuous with each other both in the main scanning direction and the sub-scanning direction.

In the case of the intensity modulation for providing smaller dots as shown in Figure 4B (70 % intensity), a spacing was first provided between dots in the main scanning direction X than in advance of the sub-scanning direction.

A high quality image was prepared similarly as in Example 1.

## Example 4

An image formation test was performed similarly as in Example 1 except that the pattern exposure-writing with a laser beam was modified as follows.

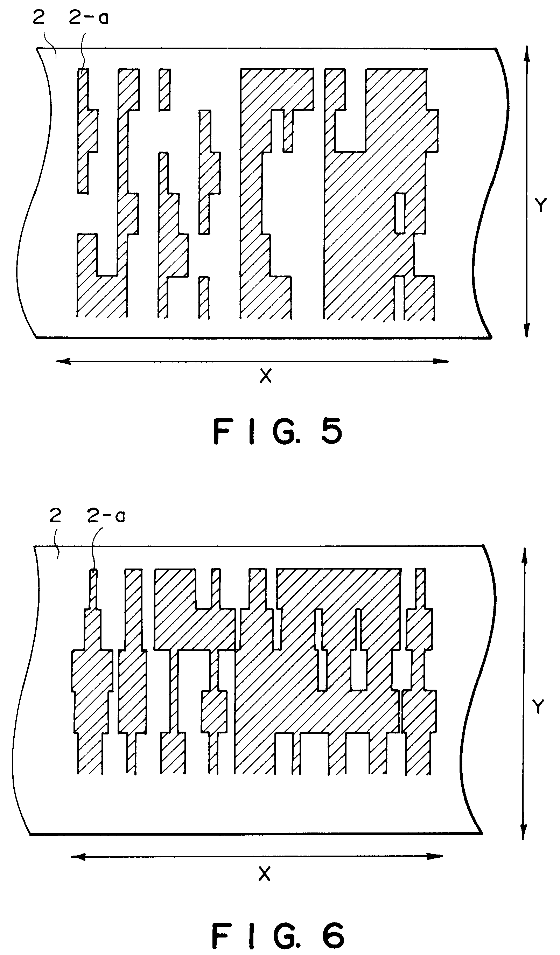

Thus, a pattern of image was formed by recording dots substantially adjacent to each other in the sub-scanning direction and having varying widths in the main scanning direction by pulse width modulation so that the respective dots had the same exposure starting position but had different widths due to different emission time to have different dot areas as shown in Figure 5, wherein the dots were caused to have 5 steps of pulse widths, i.e., 0 %, 25 %, 50 %, 75 % and 100 %. As shown in Figure 5, the adjacent dots were made continuous with each other in the sub-scanning direction Y to form pixels.

A good image was obtained in this Example similarly as in Example 1.

Example 5

An image formation test was performed through pulse width modulation during the pattern exposure writing similarly as in Example 4 except that the respective dots were formed to have different width expanding from their center in the main scanning direction X and the respective dots were substantially continuous with each other in the sub-scanning direction to form pixels, particularly at their central parts in the main scanning direction. Thus, in this embodiment, the respective dots was provided with varying exposure widths from the center to their later sides in the main scanning direction to have correspondingly different areas as shown in Figure 6, wherein the dots were caused to have 6 steps of pulse widths of 0 %, 20 %, 40 %, 60 %, 80 % and 100 %. The adjacent dots were made continuous with each other in the sub-scanning direction to form pixels.

A good image was obtained similarly as in Example 1.

Example 6

An image formation test was performed similarly as in Example 1 except that the pattern exposure-writing with a laser beam was modified as follows.

More specifically, in this Example, an areal gradation scheme using a dither matrix pattern with 16 (= 4x4) gradation levels as shown in Figure 7 was used. An increasing black area proportion was preferentially given by elongation of pixels (i.e., increase in number of connected dots) in the sub-scanning direction Y than in the main scanning direction X. Figure 7 shows the 16 gradation patterns with the order of increasing gradation levels. By using a matrix pattern comprising pixels preferentially elongated in the sub-scanning direction Y, a good image was obtained similarly as in Example 1. Figure 7 shows a matrix pattern including square dots but a better result was obtained when each dot was elongated in the sub-scanning direction.

Next, an embodiment of the present invention providing a better peeling performance of the image forming medium is explained. In this embodiment, the initiation of peeling is promoted and a better peeling performance is given in combination with the above-mentioned pixel arrangement.

An image forming medium according to this embodiment may have a peeling promotion end 100 comprising a material showing a decrease in adhesiveness on heating disposed in adhesion to an end of the release film 3 from which the peeling is initiated as shown in Figure 12 (in which a similar peeling promotion end 101 is provided at the opposite end, but only one of the ends 100 and 101 is actually used as a peeling promotion end). Such a material may for example comprise a material containing a foaming agent or a thermally polymerizable composition.

In the case of a material containing a foaming agent, the foaming agent is decomposed to generate a gas at the boundary between the support 5 and the peeling promotion end 100 or the boundary between the peeling promotion end 100 and the release film 3 to lift the peeling initiation end of the release film 3, thus promoting the peeling initiation.

The foaming agent used for the above purpose may be either an inorganic foaming agent or an organic foaming agent capable of decomposing on heating to generate a gas.

Examples of the inorganic foaming agent may include: sodium bicarbonate, ammonium carbonate, ammonium bicarbonate, ammonium nitrite, sodium carbonate, potassium bicarbonate, and potassium carbonate.

Examples of the organic foaming agent may include: nitroso compounds, such as dinitrosopentamethylenetetramine (DPT), and N,N'-dimethyl-N,N'-dinitrosoterephthalamide (DMDNTA); sulfonic acid hydrazides, such as benzenesulfonyl hydrazide (BSH), p-toluenesulfonyl hydrazide (TSH), diphenylsulfone-S,S'-disulfonyl hydrazide (DPSDSH), and 4,4'-oxybis(benzenesulfonyl hydrazide (OBSH); and azo or diazo compounds, such as azodicarbonamide (ADCA), azobisisobutyronitrile (AIBN), diazoaminobenzene (DAB), barium azodicarboxylate, and trihydrazinotriazine.

In order to promote the gas generation due to decomposition of the above-mentioned foaming agent, it is possible to use a foaming aid in combination therewith. Examples of the foaming aid may include: zinc compounds, such as zinc white, zinc caprylate, zinc nitrate, and zic-fatty acid soap; lead compounds, such as lead carbonate, lead phthalate, lead phosphite, and lead stearate; cadmium compounds, such as cadmium caprylate, cadmium caproate, cadmium laurate, cadmium myristate, and cadmium-fatty acid soap; urea, borax, and ethanolamine. By using such a foaming aid in combination with the foaming agent, it is possible to enhance the gas generation efficiency.

The foaming agent and an optional foaming aid can be mixed with an appropriate binder to form the peeling promotion end 100.

On the other hand, the thermally polymerizable composition may be obtained by mixing the above-mentioned polymerizable polymer precursor with a thermal polymerization initiator which may for example be an azo-type initiator or a peroxide type initiator.

The azo-type initiator is an organic compound having at least one nitrogen-nitrogen double bond in its molecule, and examples thereof may include: azobisisobutyronitrile, azobiscyclohexanecarbonitrile, azobismethylphenetylcarbonitrile, azobis-sec-amylonitrile, azobisphenylethane, azibiscyclohexylpropionitrile, azobismethylchloroethane, tritylazobenzene, phenylazoisobutyronitrile, and 9-(p-nitrophenylazo)-9-phenylfluorene.

The peroxide-type initiator may be almost any organic compound having at least one oxygen-oxygen bond in its molecule, and examples thereof may include: methyl ethyl ketone peroxide, cyclohexanone peroxide, 3,3,5-trimethylcyclohexanone peroxide, methylcyclohexanone peroxide, acetylacetone peroxide, 1,1-bis-(tert-butylperoxy)-3,3,5-trimethylcyclohexane, 1,1-bis(tert-butylperoxy)cyclohexane, n-butyl-4,4-bis-(tert-butylperoxy)valerate, 2,2-bis(tert-butylperoxy)-butane, tert-butyl hydroperoxide, cumene hydroperoxide, 2,5-dimethylhexane-2,5-dihydroperoxide, 1,1,3,3-tetramethylbutyl hydroperoxide, di-tert-butyl peroxide, tert-butyl cumyl peroxide, dicumyl peroxide, $\alpha,\alpha'$-bis(tert-butylperoxyisopropyl)benzene, 2,5-dimethyl-2,5-di(tert-butylperoxy)hexane, 2,5-dimethyl-2-5-di(tert-butylperoxy)hexyne-3-acetyl peroxide, isobutyryl peroxide, octanoyl peroxide, decanoyl peroxide, lauroyl peroxide, 3,5,5-trimethylhexanoyl peroxide, succinic acid peroxide, benzoyl peroxide, 2,4-dichlorobenzoyl peroxide, diisopropyl peroxydicarbonate, di-2-ethylhexyl peroxydiacrbonate, di-n-propyl peroxydicarbonate, di-2-ethoxyethyl peroxydicarbonate, dimethoxyisopropyl peroxydicarbonate, di(3-methyl-3-methoxybutyl) peroxydicarbonate, tert-butyl peroxyacetate, tert-butyl peroxyisobutyrate, tert-butyl peroxypivalic acid, tert-butyl peroxyneodecanoate, tert-butyl peroxy-3,5,5-trimethylhexanoate, tert-butyl peroxylaurate, tert-butyl peroxybenzoate, di-tert-butyl diperoxyisophthalate, 2,5-dimethyl-2-5-di(benzoylperoxy)hexane, tert-butyl peroxymaleate, and tert-butyl peroxyisopropyl carbonate.

In the case where a peeling promotion end 100 is provided as described above, the peeling promotion end 100 is heated after the imagewise exposure, i.e., the formation of a polymerized part 4-a and an unpolymerized part 4-b in the photopolymerization layer 4 (or composite photopolymerization layer 4A in Figure 11) as shown in Figure 13.

In the case where the peeling promotion end 100 comprises a foaming agent for resulting in a lower adhesiveness on heating, the peeling promotion end 100 may be heated to a temperature in the range of 30 - 230 ºC depending on the decomposition temperature of the foaming agent to generate a gas, thus lifting the peeling initiation end of the release film 3 from the support 5.

In the case where the peeling promotion end 100 comprises a thermally polymerizable composition, the peeling promotion end is heated to a temperature in the range of 60 - 200 ºC, preferably 80 -160 ºC, at which the thermal polymerization initiator is active, to form a peeling end through polymerization of the thermally polymerizable composition. In this instance, the thus formed peeling end can show a lower adhesive strength to either the support 5 or the release film 3 as may be selected by varying the thermally polymerizable composition depending on the use.

The peeling promotion end 100 can be heated separately at an appropriate temperature. However, in the case where the photopolymerization layer 4 below the release film 3 is further covered by the photosensitive layer 2 having a silver image 2-a as a mask, exposed through the photosensitive layer 2 and then heated as has been explained with reference to Figure 8, the peeling promotion end 100 may be heated simultaneously with the heating of the photopolymerization layer 4.

Then, the thus-light peeling initiation end of the release film 3 is taken and the release film 3 is peeled off in the direction of an arrow as shown in Figure 14 to form an image pattern comprising the photopolymerized parts 4-a left on the support 5.

Example 7

The following foaming composition was applied to both ends of a photopolymerization layer sandwich ("Neotrock E") as used in Example 1 to form peeling promotion ends.

| | |
|---|---|
| Dinitrosopentamethylenetetramine | 10 part(s) |
| ("Cellular D", available from | |
| Eiwa Kasei K.K.) | |
| Salicylic acid | 2 " |
| Polyvinyl butyral | 10 " |
| Acetonitrile | 200 " |

A 100 micron-thick aluminum plate cleaned for removal of rust and stain on the surface and subjected to surface roughening by sanding was used as a support and laminated with the above-treated photopolymerization layer sandwich while removing the cover film, thereby to form a partial laminate structure including a photopolymerization layer ("Neotrock E") 4 with peeling promotion ends 100 and 101, and a release film (the base film of "Neotrock E") 3 disposed on the support 5 as shown in Figure 12.

Then, an emulsion was prepared according to the following composition:

| | |
|---|---|
| Silver behenate | 5.0 part(s) |
| Behenic acid | 2.0 " |
| Silver bromide | 0.6 " |
| Polyvinyl butyral | 5.0 " |
| 4,4'-Methylenebis(2,6-di-t-butylphenol) | 3.0 " |
| Phthaladinone | 0.8 " |
| 1-Carboxymethyl-5-[(3-ethylnaphtho-<br>[1,2-d]oxazoline-2-indene)-diethylidene]-<br>3-ethylthiohydrantoin | 0.001 " |
| Xylene/n-butanol (1/1 by volume) | 60 " |

The emulsion was applied on the release film 3 and dried to form a 8 micron-thick photosensitive layer 2.

Further, the photosensitive layer 2 was laminated with a 15 micron-thick polyester film as a protective film 1 to obtain an image forming method 10 as shown in Figure 10 further provided with peeling ends 100 and 101.

The thus prepared image forming medium 10 was loaded on an image forming apparatus as shown in Figures 8 and 9 and subjected to image formation.

Thus, the image forming medium 10 prepared above was wound about a drum 11 and subjected to exposure-writing of a pattern with a laser beam issued from an He-Ne laser 6, having passed through a scanning optical system including lenses 7 and a polygonal mirror 8 and forming beam spots each having sizes of 50 microns in the main scanning direction X and 100 microns in the sub-scanning direction Y on the surface of the image forming medium 10. Then, a part of image forming medium 10 subjected to the exposure writing was heated by a heat-generating member 9 set at 125 °C to form silver image dots 2-a at the exposed parts in the photosensitive layer 2.

In this instance, the pattern was formed that the silver image dots 2-a adjacent to each other did not

13

contact each other in either of the main scanning direction X and the sub-scanning direction Y.

The image forming medium 10 having the photosensitive layer 2 having the thus-formed silver image dots 2-a as a mask was subjected to a whole-area exposure to a fluorescent light having a peakwavelength of 380 nm from a high-voltage mercury lamp 15 to form photopolymerized parts 4-a constituting an image in the photopolymerization layer 4.

Finally, the peeling end 100 was again heated to 205 °C, then peeling was initiated from the peeling end 100 by means of a peeling claw 12, and further the release film 3 together with the peeling end 101, the photosensitive layer 2 and the protective film 1 were collectively peeled off from the support 5 to leave a good image pattern 14 composed of photopolymerized parts 4-a, which image was free from lack of the polymerized parts and residue of un-polymerized parts 4-b.

Example 8

The following thermally polymerizable composition was applied to both ends of a photopolymerization layer sandwich as used in Example 7.

```
Epoxy acrylate                        100 parts

    ("V5502", available from

    Dai Nippon Ink Kogyo K.K.)

Azobisisobutyronitrile                  7    "

Methyl ethyl ketone                   100    "
```

The thus-treated photopolymerization layer sandwich was similarly used as in Example 7 for lamination of a cleaned and roughened aluminum plate and further coated with the emulsion and covered with a polyester film in the same manner as in Example 7.

Then, the peeling promotion end 100 of the thus formed image forming medium was heated at 120 °C to form a peeling end, and the image formation as in Example 7 was repeated, followed by peeling from the peeling end, whereby the peeling end portion formed by polymerization of the above composition was left on the release film 3 and a good image pattern free from lack of photopolymerized parts and residue of un-polymerized parts was left on the support 5.

As described above, according to the present invention, peeling-development of an image forming medium can be reliably performed in such a manner that a portion to be removed is securely peeled off and a portion expected to remain is securely left, whereby a high-quality image free of lack is obtained. Further, by forming a peeling promotion end, the initiation of peeling is performed without failure, whereby smooth peeling development is ensured to provide an improved image quality also in this respect.

## Claims

1. An image forming method of a peeling development-type, comprising:

    providing an image forming medium comprising a support, a polymerization layer comprising a polymerizable composition, and a release film;

    irradiating the image forming medium with image data to form an image pattern in the polymerization layer, so that the image pattern includes a polymerized part and an un-polymerized part and comprises unidirectionally elongated pixels composed of either the polymerized part or the un-polymerized part; and

    peeling the release film off the support in a direction of the elongation of the pixels to selectively leave an image corresponding to the image pattern on the support.

2. A method according to Claim 1, wherein the image forming medium is irradiated with image data conveyed by scanning laser light.

3. An image forming method of a peeling development-type, comprising:

    providing an image forming medium comprising a support, an image forming layer comprising a thermal development-type photosensitive composition and a photopolymerizable composition, and a release film;

irradiating the image forming medium with image data to form an image pattern in the image forming layer, so that the image pattern includes a polymerized part and an un-polymerized part and comprises unidirectionally elongated pixels composed of either the polymerized part or the un-polymerized part; and

peeling the release film off the support in a direction of the elongation of the pixels to selectively leave an image corresponding to the image pattern on the support.

4. A method according to Claim 3, wherein said unidirectionally elongated pixels comprises a plurality of dots connected preferentially in one direction.

5. A method according to Claim 3, wherein said image forming layer is a composite layer containing both the thermal development-type photosensitive composition and the photopolymerizable composition.

6. A method according to Claim 3, wherein said image forming layer includes a photosensitive layer comprising the thermal development-type photosensitive composition, and a photopolymerization layer comprising the photopolymerizable composition.

7. A method according to Claim 5, wherein the image forming medium includes a protective layer for shielding a fraction of light harmful to the composite layer.

8. A method according to Claim 7, wherein said release film also functions as the protective layer.

9. A method according to Claim 6, wherein the image forming medium includes a protective layer for shielding a fraction of light harmful to the photosensitive layer.

10. A method according to Claim 5, wherein the composite layer has a thickness of 0.1 micron to 2 mm.

11. A method according to Claim 6, wherein the photosensitive layer has a thickness of 0.1 micron to 2 mm, and the photopolymerization layer has a thickness of 0.2 micron to 100 microns.

12. A method according to Claim 3, wherein the release film has a thickness of 0.5 micron to 150 microns.

13. An image forming method of a peeling development-type, comprising:

providing an image forming medium comprising a support, an image forming layer comprising a thermal development-type photosensitive composition and a photopolymerizable composition, and a release film, said thermal development-type photosensitive composition comprising a photosensitive silver halide, an organic silver salt and a reducing agent, said photopolymerizable composition comprising a polymerizable polymer precursor and a photopolymerization initiator;

irradiating the image forming medium with image data to form an image pattern in the image forming layer, so that the image pattern includes a polymerized part and an un-polymerized part and comprises unidirectionally elongated pixels composed of either the polymerized part or the un-polymerized part; and

peeling the release film off the support in a direction of the elongation of the pixels to selectively leave an image corresponding to the image pattern on the support.

14. A method according to Claim 13, wherein said image forming layer is a composite layer containing both the thermal development-type photosensitive composition and the photopolymerizable composition.

15. A method according to Claim 13, wherein said image forming layer includes a photosensitive layer comprising the thermal development-type photosensitive composition, and a photopolymerization layer comprising the photopolymerizable composition.

16. An image forming method of a peeling development-type, comprising:

providing an image forming medium comprising a support, an image forming layer comprising a thermal development-type photosensitive composition and a photopolymerizable composition, and a

15

release film, said thermal development-type photosensitive composition comprising a photosensitive silver halide, an organic silver salt and a reducing agent, said photopolymerizable composition comprising a polymerizable polymer precursor and a photopolymerization initiator;

irradiating the image forming medium with image data forming an image pattern comprising unidirectionally elongated pixels,

uniformly heating the image forming medium,

uniformly irradiating the image forming medium to form in the image forming layer a polymerized part and an un-polymerized part, either one of which corresponds to the unidirectionally elongated pixels; and

peeling the release film off the support in a direction of the elongation of the pixels to selectively leave an image corresponding to the image pattern on the support.

17. A method according to Claim 16, wherein said image forming layer is a composite layer containing both the thermal development-type photosensitive composition and the photopolymerizable composition.

18. A method according to Claim 16, wherein said image forming layer includes a photosensitive layer comprising the thermal development-type photosensitive composition, and a photopolymerization layer comprising the photopolymerizable composition.

19. A method according to Claim 17, wherein the image forming medium includes a protective layer for shielding a fraction of light harmful to the composite layer.

20. A method according to Claim 19, wherein said release film also functions as the protective layer.

21. A method according to Claim 18, wherein the image forming medium includes a protective layer for shielding a fraction of light harmful to the photosensitive layer.

22. An image forming method of a peeling development-type, comprising:

providing an image forming medium comprising a support, a polymerization layer comprising a polymerizable composition, and a release film;

a peeling promotion end-forming layer being further disposed adjacent to the polymerization layer and sandwiched between the support and the release film so as to extend along one end of the release film, the peeling promotion end-forming layer comprising a material capable of decreasing its adhesiveness on heating;

irradiating the image forming medium with image data to form an image pattern in the polymerization layer, so that the image pattern includes a polymerized part and an un-polymerized part and comprises unidirectionally elongated pixels composed of either the polymerized part or the un-polymerized part, the direction of the elongation of the pixels being perpendicular to the direction of extension of the peeling promotion end-forming layer; and

peeling the release film off the support in a direction of the elongation of the pixels to selectively leave an image corresponding to the image pattern on the support.

23. A method according to Claim 22, wherein the image forming medium is irradiated with image data conveyed by scanning laser light.

24. An image forming method of a peeling development-type, comprising:

providing an image forming medium comprising a support, a polymerization layer comprising a polymerizable composition, and a release film;

a peeling promotion end-forming layer being further disposed adjacent to the polymerization layer and sandwiched between the support and the release film so as to extend along one end of the release film, the peeling promotion end-forming layer comprising a material capable of decreasing its adhesiveness on heating;

irradiating the image forming medium with image data to form an image pattern in the polymerization layer; and

peeling the release film off the support in a direction perpendicular to the direction of extension of the peeling promotion-end forming layer to selectively leave an image corresponding to the image pattern on the support.

16

**25.** A method according to Claim 24, wherein said peeling promotion end-forming layer foams on heating to decrease its adhesiveness.

**26.** An image forming apparatus of a peeling development-type, comprising:

an image forming medium comprising a support an image forming layer comprising a thermal development-type photosensitive composition and a photopolymerizable composition, and a release film;

image data irradiation means for irradiating the image forming medium with image data forming an image pattern comprising unidirectionally elongated pixels,

heating means for uniformly heating the image forming medium,

irradiation means for uniformly irradiating the image forming medium to form in the image forming layer a polymerized part and an un-polymerized part, either one of which corresponds to the unidirectionally elongated pixels; and

peeling means for peeling the release film off the support in a direction of the elongation of the pixels to selectively leave an image corresponding to the image pattern on the support.

**27.** An apparatus according to Claim 26, wherein said image data irradiation means comprises a laser light source and a scanning means including a rotating mirror.

**28.** An apparatus according to Claim 26, wherein the image forming means is supported around a drum support, and the respective said means are disposed opposite to the drum support.

**29.** A method for forming an image on a recording medium of the peeling development type which comprises irradiating the medium with image data to form an image pattern comprising unidirectionally elongated pixels.

FIG. 1

F I G. 2

F I G. 3

F I G. 4A

F I G. 4B

F I G. 5

F I G. 6

F I G. 7

F I G. 8

F I G. 9

F I G. 10

F I G. 11

F I G. 12

F I G. 13

F I G. 14

## DOCUMENTS CONSIDERED TO BE RELEVANT

EP 91307256.7

| Category | Citation of document with indication, where appropriate, of relevant passages | Relevant to claim | CLASSIFICATION OF THE APPLICATION (Int. Cl.5) |
|---|---|---|---|
| Y | JP - A - 02-176 663 (FUJI PHOTO FILM) (09.07.1990) & US-A-5 030 541 (HAYASHI) (09.07.1991) * Claims 1,10 * | 1,3,5, 13 | G 03 F 7/34 G 03 F 7/038 G 03 F 7/07 G 03 C 8/50 G 03 C 1/498 G 03 F 7/26 |
| Y | EP - B - 0 121 391 (NITTO DENKO) * Claims; fig. 3 * | 1-6,22 | |
| A | EP - B - 0 077 088 (AGFA-GEVAERT) * Claims; column 12, lines 3-36 * | 1,7-11 | |
| D,A | US - A - 4 123 274 (KNIGHT) * Claims; column 7, lines 51-55; column 12, lines 8-22 * | 1-9, 13-24 | |

TECHNICAL FIELDS SEARCHED (Int. Cl.5)

G 03 C
G 03 F

The present search report has been drawn up for all claims

| Place of search | Date of completion of the search | Examiner |
|---|---|---|
| VIENNA | 10-03-1992 | SCHÄFER |

EPO FORM 1503 03.82 (P0401)